# EUROPEAN PATENT SPECIFICATION

(11) **EP 3 883 356 B1**
(45) Date of publication and mention of the grant of the patent: **28.06.2023**
(21) Application number: 20783788.1
(22) Date of filing: 01.04.2020
(51) Int. Cl.: H05K 7/20, H02B 1/56, H02B 1/28, H01F 27/02

(54) **VENTILATION AND HEAT DISSIPATION APPARATUS, AND ELECTROMECHANICAL DEVICE**
LÜFTUNGS- UND WÄRMEABLEITUNGSVORRICHTUNG UND ELEKTROMECHANISCHE VORRICHTUNG
APPAREIL DE VENTILATION ET DE DISSIPATION DE CHALEUR ET DISPOSITIF ÉLECTROMÉCANIQUE

(30) Priority: 01.04.2019 CN 201910256985
(43) Date of publication of application: 22.09.2021
(73) Proprietor: Huawei Digital Power Technologies Co., Ltd., Shenzhen, 518043 (CN)
(72) Inventor: CHEN, Taihe, Shenzhen, Guangdong 518129 (CN); HU, Rongheng, Shenzhen, Guangdong 518129 (CN); DING, Weichao, Shenzhen, Guangdong 518129 (CN); YANG, Jianghui, Shenzhen, Guangdong 518129 (CN)
(74) Representative: MERH-IP Matias Erny Reichl Hoffmann Patentanwälte PartG mbB
(86) International application number: PCT/CN2020/082733
(87) International publication number: WO 2020/200230

(56) References cited:
- EP-A2- 2 416 638
- CN-A- 107 545 983
- CN-U- 207 634 211
- JP-A- 2008 281 286

## Description

This application claims priority to Chinese Patent Application No. 201910256985.7, filed on April 1, 2019 and entitled "VENTILATION AND HEAT DISSIPATION APPARATUS AND ELECTROMECHANICAL DEVICE".

### TECHNICAL FIELD

This application relates to the field of device protection technologies, and in particular, to a ventilation and heat dissipation apparatus and an electromechanical device.

### BACKGROUND

During operation of an electromechanical device, such as a mechanical, an electrical, or an automation device, a component such as a motor inside the electromechanical device generates a large amount of heat. A temperature inside the electromechanical device also rises after solar radiation. Therefore, heat dissipation and ventilation are required for the electromechanical device during the operation.

The related technology provides a ventilation and heat dissipation apparatus, including a main frame, an external air intake vent, an internal air intake vent, and a baffle. The internal air intake vent is located in an upper part of the main frame. The baffle is located inside the main frame and is connected to an inner wall of the main frame. The external air intake vent is located below the baffle. The main frame is connected to a device to be ventilated and cooled. External air enters the main frame through the external air intake vent, and dust or impurities in the air are blocked by the baffle. Heat generated during device operation enters the main frame through the internal air intake vent, and heat exchange is implemented inside the main frame.

The inventor finds that the related technology has at least the following problem:

Although the ventilation and heat dissipation apparatus provided in the related technology can achieve a ventilation and heat dissipation effect, the ventilation and heat dissipation apparatus still cannot meet IP rating requirements of different operating environments.
Document CN 207 634 211 U generally discloses an air inlet unit and engine belongs to the engine technology field. Air inlet unit includes the casing, first baffler, the second baffler, the guide plate, drainage element and exhaust piece, the casing has the cavity of ventilating, first baffler is located the cavity of ventilating, the second baffler is located the cavity of ventilating, first baffler and second baffler will be ventilated the cavity and separated into first cavity and second cavity, the guide plate has the guiding gutter, form the inlet channel with second cavity intercommunication between two adjacent guide plates, drainage element has drainage channel, the exhaust piece has the exhaust passage. Document JP 2008 281286 A generally relates to an air conditioner, and more particularly to a ventilation structure of an electrical component of an outdoor unit.
Document EP 2 416 638 A2 generally discloses an electronic device provided with a higher waterproofing performance, without causing a problem caused by heat emitted by an electronic part. A inverter that accommodates an electronic part in the interior of a housing is such that, while a ventilation duct is defined in an up-down direction in a front wall portion configuring a wall of the housing, and a ventilation hole that allows the ventilation duct to communicate with the exterior of the housing is formed in the lower end portion of the ventilation duct, a ventilation opening that allows the ventilation duct to communicate with the interior of the housing is formed in a position higher than the ventilation hole.
Document CN 107 545 983 A generally discloses a waterproof and ash-blocking structure of a transformer case. The structure comprises a case body, a block cover, two partition plates and a guide plate, multiple first vent holes, a drainage groove and a mounting groove are formed in the side wall of the case body, the multiple first vent holes are formed in a layered mode, the drainage groove is formed below the first vent holes, the mounting groove is formed in the inner side of the case body, and the mounting groove is communicated with the first vent holes and the drainage groove; the block cover is fixed to the inner wall of the case body and closes the mounting groove, the two partition plates are arranged in the block cover at a certain interval, the two partition plates are arranged in a parallel and staggered mode, the guide plate is arranged in the block cover in an inclined mode, one end of the guide plate is fixedly connected with the partition plate on the inner side, and the other end of the guide plate is fixedly connected with the inner wall of the block cover.

### SUMMARY

Embodiments of this application provide a ventilation and heat dissipation apparatus and an electromechanical device, to resolve the foregoing technical problem. Embodiments of the present invention are defined by the independent claim. Additional features of embodiments of the invention are presented in the dependent claims. In the following, parts of the description and drawings referring to former embodiments which do not necessarily comprise all features to implement embodiments of the claimed invention are not represented as embodiments of the invention but as examples useful for understanding the embodiments of the invention. Embodiments of the present application (or the present disclosure) provide ventilation and heat dissipation apparatus, and electromechanical device. Technical solutions are as follows:

According to one aspect, a ventilation and heat dissipation apparatus is provided. The ventilation and heat dissipation apparatus includes: a main frame configured to connect to a device to be ventilated and cooled, and a ventilation and heat dissipation assembly located inside the main frame, where
the ventilation and heat dissipation assembly includes a waterproof unit, an external ventilation unit, and an internal ventilation unit;
the waterproof unit is located between the external ventilation unit and the internal ventilation unit, and the external ventilation unit and the internal ventilation unit are arranged in a staggered manner; and
a bottom of the waterproof unit is provided with a drainage hole.

In a possible implementation, the ventilation and heat dissipation assembly further includes a first baffle and a second baffle that are disposed in a staggered manner from top to bottom, where
the first baffle is connected to a top of the waterproof unit, and the second baffle is located above the external ventilation unit.

In a possible implementation, the ventilation and heat dissipation assembly further includes a third baffle located between the waterproof unit and the main frame, where
the third baffle is located below the second baffle, and there is a reference distance between the third baffle and the external ventilation unit.

According to the invention, the waterproof unit includes a waterproof board, where
the waterproof board is located between the external ventilation unit and the internal ventilation unit, and a bottom of the waterproof board is provided with the drainage hole.

In a possible implementation, the waterproof unit further includes a rotating board, where the rotating board matches the drainage hole.

In a possible implementation, the waterproof unit further includes a rotating shaft, where
the rotating shaft is connected to the waterproof board, and the rotating board is rotatably connected to the rotating shaft.

In a possible implementation, the waterproof board includes a first waterproof subboard and a second waterproof subboard, and there is a reference angle between the first waterproof subboard and the second waterproof subboard; and
the first waterproof subboard and the second waterproof subboard are located between the external ventilation unit and the internal ventilation unit, and a bottom of the first waterproof subboard is provided with the drainage hole.

According to the invention, the main frame includes a first side board, a second side board, a top board, a bottom board, and a side wall, where
the first side board is connected to one side of the side wall, the second side board is connected to the other side of the side wall, one end of the side wall is connected to the top board, and the other end of the side wall is connected to the bottom board; and
the side wall has a first opening adapted to the external ventilation unit and a second opening adapted to the internal ventilation unit.

In a possible implementation, the ventilation and heat dissipation assembly further includes a deflector, where
the deflector is located below the internal ventilation unit, and there is an angle between the deflector and the bottom board and the first side board of the main frame.

In a possible implementation, one end of the deflector is located between the bottom board of the main frame and a bottom of the drainage hole, and the other end of the deflector is in contact with the first side board of the main frame.

In a possible implementation, the external ventilation unit includes a ventilation board, the ventilation board has a plurality of air vents, and the ventilation board is located at the first opening.

In a possible implementation, the plurality of air vents are each provided with a brim, and a concave surface of the brim is downward.

According to another aspect, an electromechanical device is provided, where the electromechanical device includes any one of the foregoing ventilation and heat dissipation apparatuses.

The technical solutions provided in the embodiments of this application have at least the following beneficial effects:

According to the ventilation and heat dissipation apparatus provided in the embodiments of this application, external rainwater is prevented, by using the waterproof unit located in the main frame, from entering the device to be ventilated and cooled, outside air enters the main frame through the external ventilation unit, and heat generated during operation of the device to be ventilated and cooled enters the main frame through the internal ventilation unit, for heat exchange. This ensures normal heat dissipation during the operation of the device, prevents rainwater from entering the device in different operating environments, and meets IP rating requirements of the electromechanical device in different operating environments.

### BRIEF DESCRIPTION OF DRAWINGS

FIG. 1 is a schematic structural diagram of a ventilation and heat dissipation apparatus according to an embodiment of this application;
FIG. 2 is a schematic structural diagram of a ventilation and heat dissipation apparatus according to an embodiment of this application;
FIG. 3 is a schematic structural diagram of a ventilation and heat dissipation apparatus according to an embodiment of this application;
FIG. 4 is a schematic diagram of a flow direction after rainwater enters a ventilation and heat dissipation apparatus according to an embodiment of this application;
FIG. 5 is a schematic structural diagram of a rotating board and a drainage hole according to an embodiment of this application;
FIG. 6 is a schematic structural diagram of a waterproof board according to an embodiment of this application;
FIG. 7 is a schematic structural diagram of a main frame according to an embodiment of this application;
FIG. 8 is a schematic structural diagram of a ventilation and heat dissipation apparatus according to an embodiment of this application;
FIG. 9 is a schematic structural diagram of a ventilation and heat dissipation apparatus according to an embodiment of this application; and
FIG. 10 is a schematic structural diagram of a ventilation board according to an embodiment of this application.

Reference numerals respectively indicate:
1-main frame, 11-first side board, 12-second side board, 13-top board, 14-bottom board, 15-side wall, 2-heat dissipation assembly, 21-waterproof unit, 211-drainage hole, 212-waterproof board, 2121-first waterproof subboard, 2122-second waterproof subboard, 213-rotating board, 22-external ventilation unit, 221-ventilation board, 23-internal ventilation unit, 24-first baffle, 25-second baffle, 26-third baffle, and 27-deflector board.

### DESCRIPTION OF EMBODIMENTS

Unless otherwise defined, all technical terms used in the embodiments of this application have the same meanings as those generally understood by a person skilled in the art. To make the objectives, technical solutions, and advantages of this application clearer, the following further describes the implementations of this application in detail with reference to the accompanying drawings.

In device protection applications, some electromechanical devices have special requirements for use. A box-type transformer station is used as an example. The box-type transformer station is used in an outdoor environment, and has particular IP rating requirements. For example, a requirement of a dustproof level of 5 means that ingress of dust is permitted, but limited ingress of dust does not interfere with normal operation of the device. A requirement of a waterproof level of 4 means that protected against splashing water from all directions. In addition, a large amount of heat generated during operation of the box-type transformer station also needs to be discharged in time. If the generated heat is not discharged in time, the normal operation of the box-type transformer station may be affected. To meet requirements of ventilation and heat dissipation of the box-type transformer station, impact caused by a changing outdoor environment needs to be avoided. For example, when the external environment is windy and rainy, rainwater needs to be prevented from entering the box-type transformer station with air, damaging the device, and affecting the normal operation of the device. In view of this, an embodiment of this application provides a ventilation and heat dissipation apparatus, to meet requirements of ventilation and heat dissipation of an electromechanical device in an operating environment similar to that of a box-type transformer station or having a use requirement similar to that of a box-type transformer station.

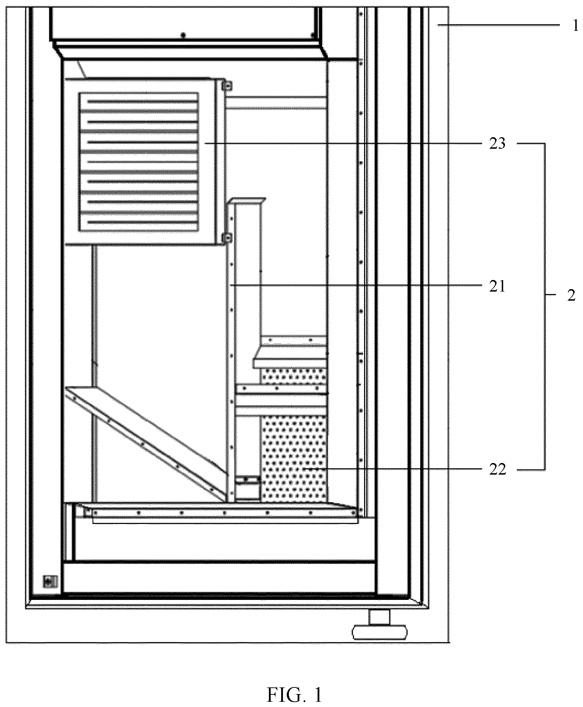

This application provides a ventilation and heat dissipation apparatus. As shown in FIG. 1, the ventilation and heat dissipation apparatus includes: a main frame 1 configured to connect to a device to be ventilated and cooled, and a ventilation and heat dissipation assembly 2 located inside the main frame 1.

The ventilation and heat dissipation assembly 2 includes a waterproof unit 21, an external ventilation unit 22, and an internal ventilation unit 23.

The waterproof unit 21 is located between the external ventilation unit 22 and the internal ventilation unit 23. The external ventilation unit 22 and the internal ventilation unit 23 are arranged in a staggered manner.

A bottom of the waterproof unit 21 is provided with a drainage hole 211.

The apparatus provided in this embodiment of this application has at least the following technical effects:
According to the ventilation and heat dissipation apparatus provided in this embodiment of this application, external rainwater is prevented, by using the waterproof unit 21 located in the main frame 1, from entering the device to be ventilated and cooled, outside air enters the main frame 1 through the external ventilation unit 22, and heat generated during operation of the device to be ventilated and cooled enters the main frame 1 through the internal ventilation unit 23, for heat exchange. This ensures normal heat dissipation during the operation of the device, prevents rainwater from entering the device due to different operating environments, and meets IP rating requirements of the electromechanical device in different operating environments.

The following further describes the ventilation and heat dissipation apparatus provided in this embodiment of this application.

The internal ventilation unit 23 and the external ventilation unit 22 provided in embodiments of this application are arranged in a staggered manner. To be specific, the external ventilation unit 22 and the internal ventilation unit 23 are disposed on two sides within the main frame 1 and are staggered at a particular distance relative to each other. In addition, left and right positions of the external ventilation unit 22 and the internal ventilation unit 23 may be exchanged based on different application scenarios of the device to be ventilated and cooled. In an example, when an application environment is different, the ventilation and heat dissipation apparatus does not need to be replaced, and only the left and right positions of the external ventilation unit 22 and the internal ventilation unit 23 need to be replaced. In this way, utilization of the ventilation and heat dissipation apparatus is improved, and costs of using the device are reduced.

A position of the internal ventilation unit 23 in the main frame 1 may be adjusted based on an operating environment of the device to be ventilated and cooled.

In an example, when a position of a component that generates a relatively large amount of heat in the device to be ventilated and cooled is relatively low, in this case, the position of the internal ventilation unit 23 in the main frame 1 needs to be adjusted, so that the ventilation and heat dissipation apparatus dissipates heat for the device. For example, as required, the position of the internal ventilation unit 23 may be above, in the middle of, or below the main frame 1, but according to the invention, not lower than the position of the external ventilation unit 22.

In embodiments of this application, both the external ventilation unit 22 and the main frame 1, and the internal ventilation unit 23 and the main frame 1 are detachably connected. In this way, when a problem occurs in the internal ventilation unit 23 and the external ventilation unit 22, it is convenient to remove and replace the internal ventilation unit 23 and the external ventilation unit 22.

In an example, the internal ventilation unit 23 may have a buckle, the main frame 1 has a groove adapted to the buckle, and the internal ventilation unit 23 is clamped to the main frame 1. Alternatively, the internal ventilation unit 23 may be provided with a first connection hole, the main frame 1 is provided with a second connection hole, and a first connecting member passes through the second connection hole and a third connection hole to connect the internal ventilation unit 23 and the main frame 1. For example, the first connection hole and the second connection hole may be bolt holes, and the first connecting member may be a bolt.

As shown in FIG. 1, the internal ventilation unit 23 may be a ventilation box of any shape, and the shape of the ventilation box may be a square, a rectangle, or the like. The shape of the internal ventilation unit 23 is not limited in this embodiment of this application.

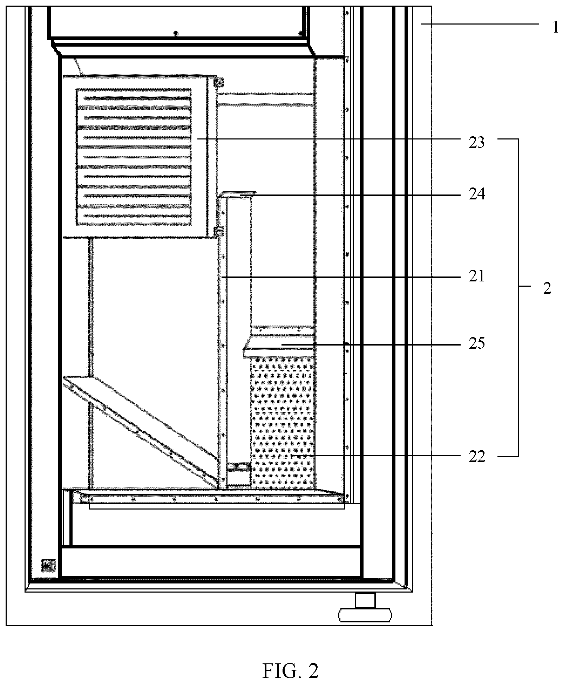

In a possible implementation, as shown in FIG. 2, the ventilation and heat dissipation assembly 2 further includes a first baffle 24 and a second baffle 25 that are disposed in a staggered manner from top to bottom.

The first baffle 24 is connected to a top of the waterproof unit 21, and the second baffle 25 is located above the external ventilation unit 22.

When the electromechanical device is used in an outdoor environment, and the outdoor environment has winds and rain, in this case, not only air enters from the external ventilation unit 22, but also rainwater enters the main frame 1 with the wind.

The second baffle 25 is provided to block most of the rainwater coming in from the external ventilation unit 22. The apparatus provided in this embodiment of this application further needs external air to enter the main frame 1. Therefore, the first baffle 24 and the second baffle 25 are disposed in a staggered manner, so that the external air can enter the main frame 1, and the air is not completely blocked below the first baffle 24.

It may be understood that because the first baffle 24 and the second baffle 25 are staggered, a channel is formed between positions at which the first baffle 24 and the second baffle 25 are staggered, and a small part of rainwater not blocked by the second baffle 25 is carried upward by air through the channel. The first baffle 24 is provided to block the remaining part of rainwater again, so that an amount of rainwater entering the main frame 1 is reduced.

The second baffle 25 is located above the external ventilation unit 22, so that rainwater entering from the external ventilation unit 22 can be prevented from entering the device to be ventilated and cooled. However, a distance between the second baffle 25 and the external ventilation unit 22 should not be excessively long, because the second baffle 25 cannot function as a water barrier with an excessively long distance.

In an example, a distance between the first baffle 24 and the second baffle 25 may be determined based on an operating environment during application. For example, when an external climate is relatively harsh, a wind speed is relatively high, and an amount of rain is relatively large, the distance between the first baffle 24 and the second baffle 25 may be relatively large. In this way, potential energy of rainwater that is not blocked may be reduced to a particular extent before blocking, thereby improving blocking efficiency.

When an external environment is relatively mild, for example, both a wind speed and an amount of rain are relatively small, or even there is no wind or rain, the distance between the first baffle 24 and the second baffle 25 may be relatively small, that is, rainwater from the outside may be blocked by setting a relatively small distance. In addition, because the distance between the first baffle 24 and the second baffle 25 is reduced, space occupied by the ventilation and heat dissipation assembly 2 in the ventilation and heat dissipation apparatus can be reduced, thereby reducing space occupancy of the ventilation and heat dissipation apparatus.

The second baffle 25 above the external ventilation unit 22 may be in a horizontal direction, or may have a particular inclination angle. This is not limited in this application, provided that a function of blocking outside water can be achieved.

The second baffle 25 is located above the external ventilation unit 22, and one end of the baffle may be connected to the main frame 1, or may be connected to the waterproof unit 21, or may be connected to both the external ventilation unit 22 and the main frame 1.

The first baffle 24 and the waterproof unit 21 may be perpendicularly connected, or may be connected at a reference angle. For example, the first baffle 24 and the waterproof unit 21 may be connected at an angle of 80°, 70°, 75°, 60°, 45°, or the like, provided that the function of blocking rainwater can be achieved.

Materials of the first baffle 24 and the second baffle 25 may be boards made of stainless steel. A thickness of each of the first baffle 24 and the second baffle 25 may be 1 centimeter, 2 centimeters, or the like, provided that the first baffle 24 and the second baffle 25 can withstand gravity action from outside rainwater. It should be noted that the foregoing thicknesses of the first baffle 24 and the second baffle 25 are merely illustrative examples, and the thicknesses of the first baffle 24 and the second baffle 25 are not limited in this embodiment of this application.

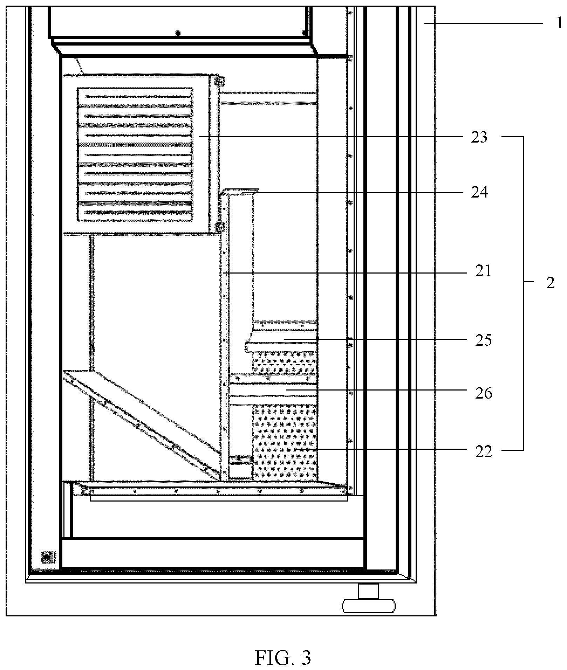

In a possible implementation, as shown in FIG. 3, the ventilation and heat dissipation assembly 2 further includes a third baffle 26 located between the waterproof unit 21 and the main frame 1.

The third baffle 26 is located below the second baffle 25, and there is a reference distance between the third baffle 26 and the external ventilation unit 22.

The third baffle 26 is disposed, so that when an external environment is relatively harsh, and both a wind speed and an amount of rain are relatively large, rainwater can be preliminarily blocked by using the third baffle 26, thereby avoiding a case in which rainwater enters the device to be ventilated and cooled because the first baffle 24 and the second baffle 25 cannot function as a good barrier when excessive rainwater enters through the external ventilation unit 22.

The reference distance is provided between the third baffle 26 and the external ventilation unit 22, so that the third baffle 26 can be prevented from shielding the external ventilation unit 22, preventing rainwater from entering, and isolating outside air from entering.

The reference distance may be determined based on an operating environment. For example, when the operating environment and condition is harsh, there are often strong winds and heavy rain, that is, a wind speed is relatively high and an amount of rain is relatively large, and a relatively large amount of rainwater may enter the main frame 1 with a strong wind. In this case, the distance between the third baffle 26 and the external ventilation unit 22 may be relatively small, to prevent excessive rainwater from entering the main frame 1 and then entering the device to be ventilated and cooled. The reference distance is not limited in this application.

A distance between the third baffle 26 and the second baffle 25 may be determined based on an operating environment. For example, when the operating environment and condition is harsh, there are often strong winds and heavy rain. In this case, a relatively large amount of rainwater may enter the main frame 1 with a strong wind. In this case, the distance between the third baffle 26 and the second baffle 25 may be relatively large. The rainwater may be first raised by a particular height between the third baffle 26 and the second baffle 25, and the rainwater is blocked after potential energy is reduced, thereby improving blocking efficiency. The distance between the third baffle 26 and the second baffle 25 is not limited in this application.

The third baffle 26 may be connected to the waterproof unit 21, or may be connected to the main frame 1, or may be connected to both the waterproof unit 21 and the main frame 1, provided that the third baffle 26 is located below the second baffle 25 and there is a reference distance between the third baffle 26 and the external ventilation unit 22.

In an example, the third baffle 26 may be clamped to the waterproof unit 21 or may be clamped to the main frame 1. For example, the waterproof unit 21 is provided with a groove and the third baffle 26 is provided with a buckle, or the main frame 1 is provided with a groove and the third baffle 26 is provided with a buckle. Alternatively, the waterproof unit 21 may be provided with a bolt hole, and the third baffle 26 is bolted to the waterproof unit 21, or the main frame 1 may be provided with a bolt hole, and the third baffle 26 is bolted to the main frame 1.

The third baffle 26 may be perpendicular to the waterproof unit 21 and the main frame 1, or may be at an angle, for example, 80°, 70°, 75°, 60°, or 45°, provided that a function of blocking water can be achieved.

A material of the third baffle 26 may be a board made of stainless steel. A thickness of the third baffle 26 may be 1 centimeter, 2 centimeters, or the like, provided that the third baffle 26 can withstand gravity action from outside rainwater. It should be noted that the foregoing thickness of the third baffle 26 is merely an illustrative example, and the thicknesses of the third baffle 26 is not limited in this embodiment of this application.

According to the invention, the waterproof unit 21 includes a waterproof board 212.

The waterproof board 212 is located between the external ventilation unit 22 and the internal ventilation unit 23, and a bottom of the waterproof board 212 has a drainage hole 211.

In embodiments of this application, the waterproof board 212 is disposed, and the external ventilation unit 22 and the internal ventilation unit 23 are respectively located on two sides of the waterproof board 212.

A position of the waterproof board 212 between the external ventilation unit 22 and the internal ventilation unit 23 is not limited, and may be determined based on a volume or a size of each of the external ventilation unit 22 and the internal ventilation unit 23.

In an example, when a space position in the main frame 1 remains unchanged and the size of the internal ventilation unit 23 is relatively large, space occupied by the external ventilation unit 22 is reduced. In this case, the waterproof board 212 is relatively close to the external ventilation unit 22 in the main frame 1.

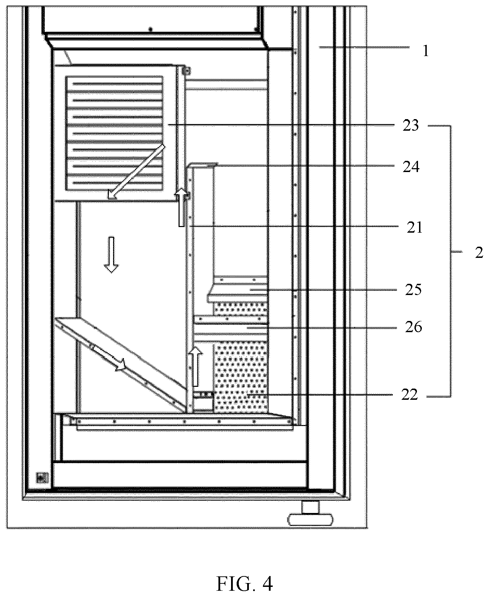

FIG. 4 shows a flow direction of external rainwater entering the main frame 1 according to an embodiment of this application. An arrow in FIG. 4 shows the direction of the rainwater after the rainwater enters the main frame 1. When an external environment is windy and rainy, and both a wind speed and an amount of rain are relatively large, rainwater entering the main frame 1 with a strong wind cannot be completely blocked by the third baffle 26, the second baffle 25, and the first baffle 24. The rainwater continues to rise from a top of the first baffle 24 under action of the wind speed. When the rainwater rises to a particular position and meets the main frame 1, the rainwater deflects to a side that is of the waterproof board 212 that is located in the internal ventilation unit 23 under drive of the strong wind due to blocking by the waterproof board 212. Then the rainwater descends under action of gravity. The rainwater flows out through the drainage hole 211 at the bottom of the waterproof board 212 and is discharged through the external ventilation unit 22. In this way, rainwater entering with the wind can be further processed, thereby preventing the rainwater from entering the device to be ventilated and cooled and from affecting operation of the device.

There may be a plurality of drainage holes 211. For example, two rows of drainage holes 211, three rows of drainage holes 211, or four rows of drainage holes 211 may be disposed in a lower part of the waterproof board 212. A size of the drainage hole 211 may be determined based on an environment during application. For example, when an environment in which the device to be ventilated and cooled is located is relatively harsh, and strong winds and heavy rain often occur, a relatively large amount of rainwater may enter the main frame 1. In addition, because both a wind speed and an amount of rain are relatively large, the third baffle 26, the second baffle 25, and the first baffle 24 can block a small amount of rainwater. In this case, a relatively large amount of rainwater may pass through the first baffle 24. Therefore, a drainage hole 211 of a relatively large size needs to be opened to meet a draining requirement.

Optionally, a height of the waterproof board 212 is lower than a height of the main frame 1. Rainwater that is not blocked by the first baffle 24, the second baffle 25, and the third baffle 26 falls through the other side of the first baffle 24 and is discharged through the drainage hole 211. Therefore, a height of the first baffle 24 should be lower than the height of the main frame 1, to avoid a case in which the height of the first baffle 24 is excessively high, the wind speed is not sufficiently strong, and the rainwater cannot fall through the other side of the first baffle 24 when the rainwater rises.

In an example, the height of the waterproof board 212 may be slightly higher than the height of the first baffle 24. The height of the waterproof board 212 may be determined based on an environment in which the device is located during application.

For example, during application, if a climate condition of an environment in which the device is located is relatively poor, and there are many cases of strong winds and heavy rain, the height of the waterproof board 212 may be set relatively high. After rainwater rises by a particular height and potential energy decreases, an amount of rainwater falling on one side of the waterproof board 212 is relatively reduced.

It may be understood that a height of the waterproof board 212 also needs to match a size of the main frame 1.

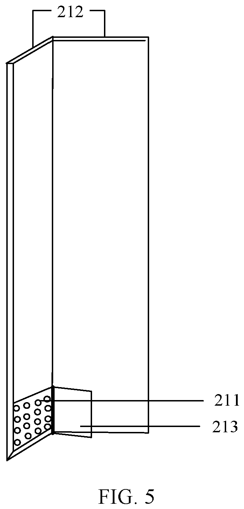

In a possible implementation, as shown in FIG. 5, the waterproof unit 21 further includes a rotating board 213.

The rotating board 213 matches the drainage hole 211.

According to the rotating board 213 provided in this embodiment of this application, when the rotating board 213 rotates to the drainage hole 211, the drainage hole 211 is closed, and when the rotating board 213 is away from the drainage hole 211, the drainage hole 211 is open.

It may be understood that, when a wind speed and an amount of rain in an external environment are relatively large, if the drainage hole 211 is always open, some rainwater may directly enter the other side of the waterproof board 212 through the drainage hole 211. Therefore, the rotating board 213 is disposed. In this way, when winds and rain enter the external ventilation unit 22, due to action of a wind force, the rotating board 213 rotates toward the drainage hole 211 under impact of the wind force and gravity of the rainwater, and further closes the drainage hole 211, so that rainwater is prevented from entering through the drainage hole 211. After the wind speed and the amount of rain decrease, impact action of the wind force and the rainwater also decreases accordingly. The rainwater on the other side of the waterproof board 212 impacts the rotating board 213 under action of gravity. The rotating board 213 is away from the drainage hole 211, the drainage hole 211 is open, and the rainwater is discharged.

When rotating to the drainage hole 211, the rotating board 213 closes the drainage hole 211 under forces of the wind and rain. Therefore, the rotating board 213 matches the drainage hole 211.

For example, when the drainage hole 211 is a circular drainage hole, the rotating board 213 may be a square, rectangular, or circular board, but it needs to be ensured that a surface area of the rotating board 213 is greater than a total opening area of the drainage hole 211.

This embodiment of this application provides an example. Referring to FIG. 5, the drainage hole 211 may be a plurality of rows of rectangular water holes that are provided on the waterproof board 212, and the rotating board 213 may be a rectangular board that matches the rectangular water holes.

When rotating to the waterproof board 212, the rotating board 213 needs to block rainwater on the other side of the waterproof board 212. Therefore, the rotating board 213 needs to be a board capable of bearing particular pressure. For example, the rotating board 213 may be a stainless steel board or a polyvinyl chloride board. However, a weight of the rotating board 213 should not be excessively heavy. If the weight of the rotating board 213 is excessively heavy, when forces of winds and rain entering the main frame 1 are relatively small, the rotating board 213 cannot rotate to close the drainage hole 211.

The rotating board 213 rotates, under the forces of winds and rain entering from the external ventilation unit 22, to close or open the drainage hole 211. Therefore, a length of the rotating board 213 should not be excessively long. If the length of the rotating board 213 is excessively long, the external ventilation unit 22 is blocked, and air entry is affected, and rotation cannot be implemented. In addition, the length of the rotating board 213 should not be excessively short. If the length of the rotating board 213 is excessively short, a force-bearing area is caused to be excessively small, and rotation cannot be implemented.

In an example, a height of the rotating board 213 matches a height of the drainage hole 211, and a length of the rotating board 213 matches a size of the drainage hole 211. That is, the length of the rotating board 213 not only has a sufficient force-bearing area for rotation, but also does not affect normal operation of the ventilation and heat dissipation apparatus. A size of the rotating board 213 is not limited in this embodiment of this application.

In a possible implementation, the waterproof unit 21 further includes a rotating shaft.

The rotating shaft is connected to the waterproof board 212, and the rotating board 213 is rotatably connected to the rotating shaft.

The rotating shaft provided in this embodiment of this application is connected to the waterproof board 212, and is further rotatably connected to the rotating board 213, so that the rotating board 213 can rotate around the rotating shaft.

In an example, the rotating shaft provided in this embodiment of this application may be a hinge. One end of the hinge is connected to the waterproof board 212 and the other end of the hinge is connected to the rotating board 213. The rotating board 213 may be connected to the waterproof board 212 by using the hinge to implement relative rotation.

For example, the hinge provided in this application may be a damping hinge, and when a rotatable function is implemented, noise generated when the hinge rotates can be reduced.

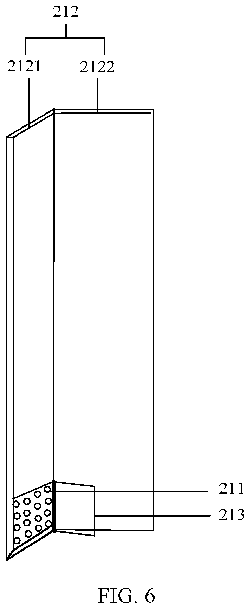

In a possible implementation, as shown in FIG. 6, the waterproof board 212 includes a first waterproof subboard 2121 and a second waterproof subboard 2122, and there is a reference angle between the first waterproof subboard 2121 and the second waterproof subboard 2122.

The first waterproof subboard 2121 and the second waterproof subboard 2122 are located between the external ventilation unit 22 and the internal ventilation unit 23, and a bottom of the first waterproof subboard 2121 has a drainage hole 211.

The first waterproof subboard 2121 and the second waterproof subboard 2122 provided in this embodiment of this application are each a baffle having a specific thickness. The first waterproof subboard 2121 and the second waterproof subboard 2122 may be connected at an angle of 90°, or may be connected at an angle of 30°, 40°, 45°, 60°, or the like.

The first baffle 24 provided in this embodiment of this application is connected to the first waterproof subboard 2121, or is connected to the second waterproof subboard 2122, or is connected to both the first waterproof subboard 2121 and the second waterproof subboard 2122. The first waterproof subboard 2121 may be connected to the main frame 1, or may be connected only to the second waterproof subboard 2122. An angle between the first baffle 24 and the first waterproof subboard 2121 may be adjusted by adjusting a position of either of the first baffle 24 and the first waterproof subboard 2121.

The first waterproof subboard 2121 needs to block rainwater from the outside. Therefore, it should be ensured that the first waterproof subboard 2121 and the main frame 1 are sealed, to prevent rainwater from directly entering below the internal ventilation unit 23 through a gap between the first waterproof subboard 2121 and the main frame 1.

The second baffle 25 provided in this embodiment of this application is connected to the second waterproof subboard 2122, and is located above the waterproof unit 21. The third baffle 26 is connected to the first waterproof subboard 2121.

Because the second baffle 25 and the third baffle 26 are connected in a staggered manner, a channel is formed between positions at which the second baffle 25 and the third baffle 26 are staggered, and between the first waterproof subboard 2121 and the second waterproof subboard 2122. Rainwater that is not blocked rises from the channel formed between the positions at which the second baffle 25 and the third baffle 26 are staggered, and between the first waterproof subboard 2121 and the second waterproof subboard 2122. Then, after being blocked by the first baffle 24, the rainwater is deflected to one side of the internal ventilation unit 23 under action of a wind force, and is discharged through the drainage hole 211 in a lower part of the first waterproof subboard 2121.

The second baffle 25 and the second waterproof subboard 2122 may be detachably connected, and the third baffle 26 and the first waterproof subboard 2121 may be detachably connected. For example, the connections may be clamped or bolted connections.

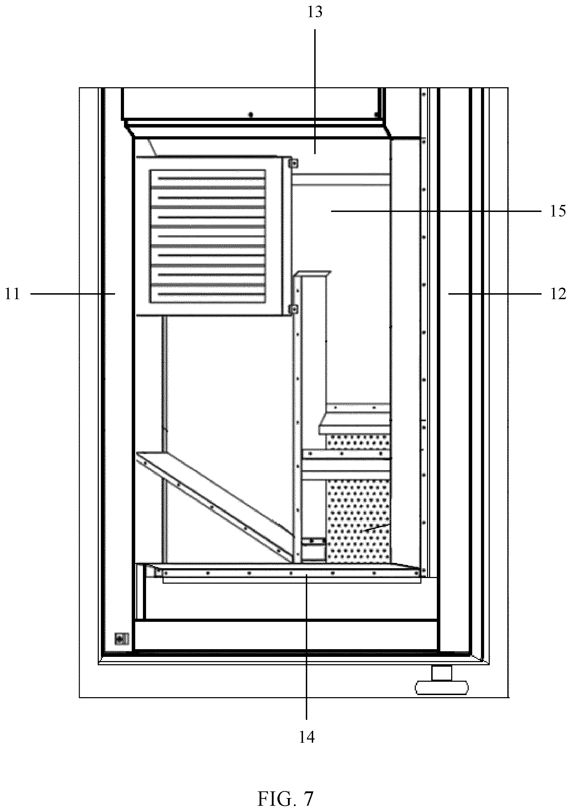

According to the invention, as shown in FIG. 7, the main frame 1 includes a first side board 11, a second side board 12, a top board 13, a bottom board 14, and a side wall 15.

The first side board 11 is connected to one side of the side wall 15, the second side board 12 is connected to the other side of the side wall 15, one end of the side wall 15 is connected to the top board 13, and the other end of the side wall 15 is connected to the bottom board 14.

The side wall 15 has a first opening adapted to the external ventilation unit 22 and a second opening adapted to the internal ventilation unit 23.

The main frame 1 provided in embodiments of this application forms a semi-open accommodation space by using the first side board 11, the second side board 12, the top board 13, the bottom board 14, and the side wall 15. The waterproof unit 21 is located in the accommodation space, and processes rainwater entering the accommodation space, to prevent the rainwater from entering the device to be ventilated and cooled.

The first side board 11, the second side board 12, and the side wall 15 of the main frame 1 may be detachably connected, the side wall 15 and the bottom board 14 may be detachably connected, and the side wall 15 and the top board 13 may be detachably connected. For example, the connections may be bolted connections. For example, the side wall 15, the first side board 11, and the second side board 12 all have bolt holes. Alternatively, the connections may be riveted connections, clamped connections, or the like. The foregoing connections are used, so that when a volume of the device to be ventilated and cooled is relatively large or relatively small, the device can be easily removed for replacement, or the device can be removed and replaced when the device is damaged.

A size of the main frame 1 provided in this embodiment of this application is determined based on a size of the device to be ventilated and cooled during actual application.

In an example, when the device to be ventilated and cooled is a box-type transformer station, a height of the side wall 15 of the main frame 1 matches a height of the box-type transformer station, and a width of the side wall 15 of the main frame 1 matches a size of a transformer or a size of a motor in the box-type transformer station. Heights of the first side board 11 and the second side board 12 are adapted to the height of the box-type transformer station. This is not limited in this embodiment of this application.

The main frame 1 provided in this embodiment of this application is configured to connect to the device to be ventilated and cooled. In an example, when the main frame 1 is to be connected to the device to be ventilated and cooled, the main frame 1 is detachably connected to the device to be ventilated and cooled by using the first side board 11, the second side board 12, the top board 13, and the bottom board 14. For example, the two side boards 11, the top board 13, and the bottom board 14 may be provided with bolt holes, and a housing that is of the device to be ventilated and cooled and that is connected to the main frame 1 is provided with bolt holes that match the bolt holes. Alternatively, the first side board 11, the second side board 12, the top board 13, and the bottom board 14 may be provided with buckles, and a housing that is of the device to be ventilated and cooled and that is connected to the main frame 1 is provided with grooves adapted to the buckles.

A material of the main frame 1 may be a main frame made of stainless steel, and can resist corrosion of rainwater in an external environment. In addition, the main frame made of stainless steel can reduce an overall weight of the ventilation and heat dissipation apparatus, and when applied to a device that needs to be moved, an overall weight of the device is reduced. Alternatively, the main frame 1 may be a main frame made of other alloy materials, provided that the main frame is made of a material that can resist corrosion of external rainwater and has particular strength and hardness.

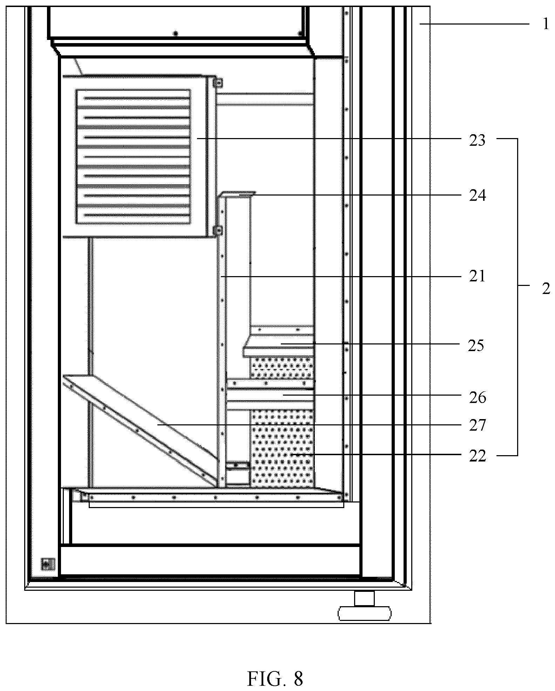

In a possible implementation, as shown in FIG. 8, the ventilation and heat dissipation assembly 2 further includes a deflector 27.

The deflector 27 is located below the internal ventilation unit 23, and there is an angle between the deflector 27 and the bottom board 14 and the first side board 11 of the main frame 1.

Rainwater is guided to the drainage hole 211 in the lower part of the first waterproof subboard 2121 by using the deflector 27 provided in this embodiment of this application. In this way, drainage of accumulated water is accelerated, and drainage efficiency is improved. Alternatively, when a small amount of water is accumulated on one side of the first side board 11 and is difficult to discharge in the horizontally placed main frame 1, the accumulated water can be rapidly discharged through the deflector 27.

A thickness of the deflector 27 may be determined based on an application environment of the device to be ventilated and cooled during application. For example, when a relatively large amount of winds and rain occur in the application environment of the device to be ventilated and cooled, a relatively large amount of rainwater enters one side of the first side board 11. Therefore, the thickness of the deflector 27 may be relatively large. For example, the thickness may be 2 centimeters or 3 centimeters. When a relatively small amount of winds and rain occur in the application environment of the device to be ventilated and cooled, a wind at a relatively low speed and a relatively small amount of rainwater enter one side of the first side board 11. Therefore, the thickness of the deflector 27 may be relatively small. For example, the thickness may be 0.5 centimeter or 1 centimeter. It should be noted that the foregoing thicknesses are merely examples, and the thickness of the deflector 27 is not limited in this embodiment of this application.

A width of the deflector 27 may be adapted to the size of the drainage hole 211, so that the accumulated water flowing down from the deflector 27 can directly enter the drainage hole 211.

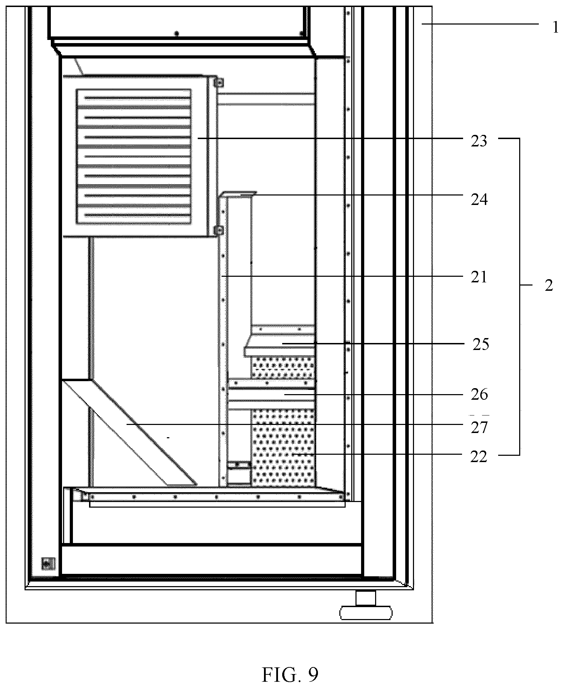

There is an angle between the deflector 27 and the bottom board 14 and the first side board 11 of the main frame 1. As shown in FIG. 9, one end of the deflector 27 may be disposed at any position of the bottom board 14 of the main frame 1, and the other end of the deflector 27 may be disposed against the first side board 11 of the main frame 1.

In an example, one end of the deflector 27 may be disposed against the first side board 11 of the main frame 1, and the other end of the deflector 27 may be placed on the bottom board 14 of the main frame 1. The angle between the deflector 27 and the first side board 11 may be adjusted by moving a position of the deflector 27 on the bottom board 14, for example, by moving the deflector 27 in a direction approaching the first waterproof subboard 2121 or away from the first waterproof subboard 2121, to further adjust a flow-conducting capacity of the deflector 27.

In an example, one end of the deflector 27 is easily slidable on the bottom board 14 of the main frame 1, and one end of the deflector 27 may be connected to the bottom board 14 of the main frame 1 after a flow guide angle is adjusted.

In a possible implementation, one end of the deflector 27 is located between the bottom board 14 of the main frame 1 and a bottom of the drainage hole 211, and the other end of the deflector 27 is in contact with the first side board 11 of the main frame 1.

It may be understood that because the deflector 27 is to divert water on one side of the first waterproof subunit 2121, the deflector 27 should be located between the bottom of the drainage hole 211 and the bottom board 14 of the main frame 1, without blocking the drainage hole 211.

The other end of the deflector 27 may be connected to the first side board 11 of the main frame 1 after the guide angle is set. Alternatively, the other end of the deflector 27 may be placed on the first side board 11, to be in contact with the first side board 11.

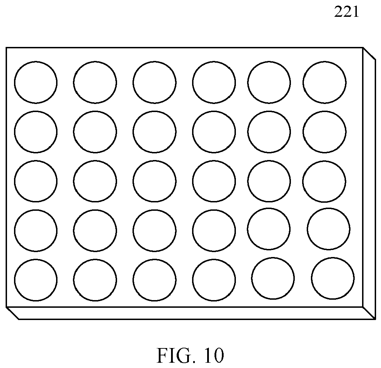

In a possible implementation, as shown in FIG. 10, the external ventilation unit 22 includes a ventilation board 221. The ventilation board 221 has an air vent, and the ventilation board 221 is located at the first opening.

In an embodiment not according to the invention, the ventilation board 221 may be fixedly connected to the main frame 1. For example, the ventilation board 221 is welded to the first opening of the main frame 1. In this way, when the ventilation and heat dissipation apparatus is collided or impacted, the ventilation board 221 does not fall, thereby ensuring stability of the ventilation and heat dissipation apparatus.

According to the invention, the ventilation board 221 is detachably connected to the main frame 1, to facilitate removal and replacement when the air vent is blocked.

The ventilation and heat dissipation apparatus provided in this embodiment of this application may be used in an indoor environment or an outdoor environment. When the ventilation and heat dissipation apparatus is used in an outdoor environment, winds and rain may occur due to climate change. In view of this, a material of the ventilation board 221 may be a board made of a stainless steel material, or may be a board made of a material that is not easily corroded by rainwater, such as aluminum alloy. In this way, a service life of the apparatus can be increased, and manufacturing costs of the apparatus can be reduced.

A shape of the ventilation board 221 may be a board of a square shape, a rectangle shape, a trapezoidal shape, or an irregular shape. The shape of the ventilation board 221 may be adapted to a shape of the first opening. This is not limited in this embodiment of this application.

A size of the ventilation board 221 may be determined based on a status of the device to be ventilated and cooled during application. In an example, when the device to be ventilated and cooled is a relatively large box-type transformer station, because power of a transformer or a high-voltage electrical device installed in the box-type transformer station is relatively large, a relatively large amount of heat is generated, and a relatively large amount of air needs to enter the ventilation and heat dissipation apparatus for heat exchange. In this case, the size of the ventilation board 221 may be relatively large, so that a relatively large amount of air enters the main frame 1.

When the device to be ventilated and cooled is a low-power motor, because the power of the motor is relatively small, a relatively small amount of heat is generated, and an amount of air that needs to be dissipated is also relatively small. In this case, the ventilation board 221 may be disposed relatively small, so that not only a requirement for an amount of air for heat exchange can be met, but also space occupancy of the apparatus is not affected.

The ventilation board 221 is provided with a plurality of air vents, so that dust, impurities, and the like in outside air can be isolated, and air entering the main frame 1 can be preliminarily filtered, to prevent the dust, the impurities, and the like in the air from blocking the main frame 1 and affecting normal working of the ventilation and heat dissipation apparatus.

A size of the air vent may be determined based on a scenario during application. For example, when the ventilation and heat dissipation apparatus provided in this embodiment of this application is applied to a box-type transformer station, because application environments of the box-type transformer stations are different, climate conditions are also different, when the box-type transformer station is located in a mountainous area with a relatively poor environment, it may be difficult for air to enter the heat dissipation frame 1 due to large and miscellaneous impurities in rainwater. In this case, a diameter of the air vent may be set to be relatively large, so that outside air can easily enter the main frame 1.

A shape of the air vent may be a circle, a triangle, a square, a rectangle, a star, or other various shapes, and may be set based on an actual application scenario. For example, when the apparatus provided in this embodiment of this application is used for a box-type transformer station, and the box-type transformer station is located at an important urban location or a residential living area, the shape of the air vent may be determined based on a ambient environment, so that a level of integration with the ambient environment can be improved.

In a possible implementation, the plurality of air vents are each provided with a brim, and a concave surface of the brim faces the ground.

The plurality of air vents are provided with the brims, so that sundries from the outside, such as cotton threads, paper towels, silk threads, or leaves blown by a strong wind, can be shielded.

It may be understood that, when an external environment is windy and rainy, some rainwater can also be shielded by using the brims on the air vents, thereby reducing an amount of rainwater entering the main frame 1 from a source, without affecting ingress of outside air into the main frame 1.

A size of the brim matches the size of the air vent to achieve a better shielding effect.

Optionally, the plurality of air vents are each provided with a filter screen.

Air entering the main frame 1 can be filtered again by disposing the filter screens on the plurality of air vents to filter out large particle impurities in the air. When the external environment is windy and rainy or haily, some rainwater and hail can be blocked, and sundries in the rainwater mixed with strong winds can also be filtered.

For example, the filter screen may be bonded to a hole wall of the air vent, or may be bonded to the entire ventilation board 221.

A mesh of the filter screen should not be excessively small. If the mesh is excessively small, outside air may be prevented from entering the main frame 1, reducing heat dissipation efficiency of the device. If the mesh is excessively large, dust or impurities with a relatively large grain size may enter the main frame 1, affecting normal operation of the device. A size of the mesh of the filter screen may be determined based on an operating environment of the device to be ventilated and cooled. This is not limited in this embodiment of this application.

In a possible implementation, the external ventilation unit 22 further includes a connecting member, and the ventilation board 221 is connected to the main frame 1 by using the connecting member.

In an example, the connecting member provided in this embodiment of this application may be a buckle, and the ventilation board 221 may be clamped to the main frame 1. The connecting member may alternatively be a bolt, the main frame 1 has a bolt hole, and the ventilation board 221 is connected to the main frame 1 by using the bolt. In this way, when the ventilation board 221 is blocked or damaged, the ventilation board 221 can be easily removed and replaced.

According to another aspect, an embodiment of this application provides an electromechanical device. The device includes any one of the foregoing ventilation and heat dissipation apparatuses.

According to the electromechanical device provided in this embodiment of this application, heat exchange is performed on heat generated in the electromechanical device by using a ventilation and heat dissipation apparatus, so that the electromechanical device operates efficiently.

All the foregoing optional technical solutions may be combined in any manner to form optional embodiments of this disclosure, all embodiments being defined by the appended claims only, and details are not described herein again.

The foregoing descriptions are merely illustrative embodiments of this application, but are not intended to limit the protection scope of this application, which is defined by the appended claims.

## Claims

1. A ventilation and heat dissipation apparatus, wherein the ventilation and heat dissipation apparatus comprises: a main frame (1) configured to be connected to a device to be ventilated and cooled, and a ventilation and heat dissipation assembly (2) located inside the main frame (1), wherein
the ventilation and heat dissipation assembly (2) comprises a waterproof unit (21) for preventing external water from entering the device to be ventilated and cooled, an external ventilation unit (22) for allowing outside air to enter the main frame (1), and an internal ventilation unit (23) for allowing heat generated during operation of the device to be ventilated and cooled to enter the main frame (1);
the waterproof unit (21), including a waterproof board (212), is located between the external ventilation unit (22) and the internal ventilation unit (23), and the external ventilation unit (22) and the internal ventilation unit (23) are arranged in a staggered manner, wherein the external ventilation unit (22) and the internal ventilation unit (23) are respectively located on two sides of the waterproof board (212) and the position of the internal ventilation unit (23) is not lower than the position of the external ventilation unit (22); and
a bottom of the waterproof board (212) is provided with a drainage hole (211), so that the external water on a side of the waterproof board (212) that is located in the internal ventilation unit (23) flows out through the drainage hole (211) at the bottom of the waterproof board (212) and is discharged through the external ventilation unit (22),
wherein the main frame (1) comprises a first side board (11), a second side board (12), a top board (13), a bottom board (14), and a side wall (15), wherein
the first side board (11) is connected to one side of the side wall (15), the second side board (12) is connected to the other side of the side wall (15), one end of the side wall (15) is connected to the top board (13), and the other end of the side wall (15) is connected to the bottom board (14); and
the side wall (15) has a first opening adapted to the external ventilation unit (22) and a second opening adapted to the internal ventilation unit (23), and
wherein both the external ventilation unit (22) and the main frame (1), and the internal ventilation unit (23) and the main frame (1) are detachably connected

2. The ventilation and heat dissipation apparatus according to claim 1, wherein the ventilation and heat dissipation assembly (2) further comprises a first baffle (24) and a second baffle (25) that are disposed in a staggered manner from top to bottom, wherein
the first baffle (24) is connected to a top of the waterproof unit (21), and the second baffle (25) is located above the external ventilation unit (22).

3. The ventilation and heat dissipation apparatus according to claim 1 or 2, wherein the ventilation and heat dissipation assembly (2) further comprises a third baffle (26) located between the waterproof unit (21) and the main frame (1), wherein
the third baffle (26) is located below the second baffle (25), and there is a reference distance between the third baffle (26) and the external ventilation unit (22).

4. The ventilation and heat dissipation apparatus according to any one of claims 1 to 3, wherein the waterproof unit (21) further comprises a rotating board (213), wherein
the rotating board (213) matches the drainage hole (211).

5. The ventilation and heat dissipation apparatus according to claim 4, wherein the waterproof unit (21) further comprises a rotating shaft, wherein
the rotating shaft is connected to the waterproof board (212), and the rotating board (213) is rotatably connected to the rotating shaft.

6. The ventilation and heat dissipation apparatus according to any one of claims 1 to 5, wherein the waterproof board (212) comprises a first waterproof subboard (2121) and a second waterproof subboard (2122), and there is a reference angle between the first waterproof subboard (2121) and the second waterproof subboard (2122); and
the first waterproof subboard (2121) and the second waterproof subboard (2122) are located between the external ventilation unit (22) and the internal ventilation unit (23), and a bottom of the first waterproof subboard (2121) is provided with the drainage hole (211).

7. The ventilation and heat dissipation apparatus according to any one of claims 1 to 6, wherein the ventilation and heat dissipation assembly (2) further comprises a deflector (27) for guiding the water to the drainage hole (211), wherein
the deflector (27) is located below the internal ventilation unit (23), and there is an angle between the deflector (27) and the bottom board (14) and the first side board (11) of the main frame (1).

8. The ventilation and heat dissipation apparatus according to claim 7, wherein one end of the deflector (27) is located between the bottom board (14) of the main frame (1) and a bottom of the drainage hole (211), and the other end of the deflector (27) is in contact with the first side board (11) of the main frame (1).

9. The ventilation and heat dissipation apparatus according to any one of claims 1 to 6, wherein the external ventilation unit (22) comprises a ventilation board (221), the ventilation board (221) has a plurality of air vents, and the ventilation board (221) is located at the first opening

10. The ventilation and heat dissipation apparatus according to claim 9, wherein the plurality of air vents are each provided with a brim, and a concave surface of the brim is downward.

11. An electromechanical device, wherein the electromechanical device comprises the ventilation and heat dissipation apparatus according to any one of claims 1 to 10.

## Patentansprüche

1. Lüftungs- und Wärmeableitungsvorrichtung, wobei die Lüftungs- und Wärmeableitungsvorrichtung Folgendes umfasst:
einen Hauptrahmen (1), der dazu konfiguriert ist, mit einer zu lüftenden und zu kühlenden Vorrichtung verbunden zu werden, und eine Lüftungs- und Wärmeableitungsbaugruppe (2), die sich innerhalb des Hauptrahmens (1) befindet, wobei
die Lüftungs- und Wärmeableitungsbaugruppe (2) eine wasserdichte Einheit (21) zum Verhindern des Eindrangs von externem Wasser in die zu lüftende und zu kühlende Vorrichtung, eine externe Lüftungseinheit (22) zum Ermöglichen des Einströmens von Außenluft in den Hauptrahmen (1) und eine interne Lüftungseinheit (23) zum Ermöglichen des Einströmens von Wärme, die während des Betriebs der zu lüftenden und zu kühlenden Vorrichtung erzeugt wird, in den Hauptrahmen (1) umfasst;
sich die wasserdichte Einheit (21), die eine wasserdichte Platte (212) beinhaltet, zwischen der externen Lüftungseinheit (22) und der internen Lüftungseinheit (23) befindet und die externe Lüftungseinheit (22) und die interne Lüftungseinheit (23) versetzt angeordnet sind, wobei sich die externe Lüftungseinheit (22) und die interne Lüftungseinheit (23) jeweils auf zwei Seiten der wasserdichten Platte (212) befinden und die Position der internen Lüftungseinheit (23) nicht niedriger als die Position der externen Lüftungseinheit (22) ist; und
eine Unterseite der wasserdichten Platte (212) mit einem Drainageloch (211) versehen ist, so dass das externe Wasser auf einer Seite der wasserdichten Platte (212), die sich in der internen Lüftungseinheit (23) befindet, durch das Drainageloch (211) an der Unterseite der wasserdichten Platte (212) abfließt und durch die externe Lüftungseinheit (22) abgeführt wird,
wobei der Hauptrahmen (1) eine erste Seitenplatte (11), eine zweite Seitenplatte (12), eine obere Platte (13), eine untere Platte (14) und eine Seitenwand (15) umfasst, wobei die erste Seitenplatte (11) mit einer Seite der Seitenwand (15) verbunden ist, die zweite Seitenplatte (12) mit der anderen Seite der Seitenwand (15) verbunden ist, ein Ende der Seitenwand (15) mit der oberen Platte (13) verbunden ist und das andere Ende der Seitenwand (15) mit der unteren Platte (14) verbunden ist; und
die Seitenwand (15) eine erste an die externe Lüftungseinheit (22) angepasste Öffnung und eine zweite an die interne Lüftungseinheit (23) angepasste Öffnung aufweist, und
wobei sowohl die externe Lüftungseinheit (22) und der Hauptrahmen (1) als auch die interne Lüftungseinheit (23) und der Hauptrahmen (1) lösbar verbunden sind.

2. Lüftungs- und Wärmeableitungsvorrichtung nach Anspruch 1, wobei die Lüftungs- und Wärmeableitungsbaugruppe (2) ferner ein erstes Leitblech (24) und ein zweites Leitblech (25) umfasst, die von oben nach unten versetzt angeordnet sind, wobei das erste Leitblech (24) mit einer Oberseite der wasserdichten Einheit (21) verbunden ist und sich das zweite Leitblech (25) über der externen Lüftungseinheit (22) befindet.

3. Lüftungs- und Wärmeableitungsvorrichtung nach Anspruch 1 oder 2, wobei die Lüftungs- und Wärmeableitungsbaugruppe (2) ferner ein drittes Leitblech (26) umfasst, das sich zwischen der wasserdichten Einheit (21) und dem Hauptrahmen (1) befindet, wobei
sich das dritte Leitblech (26) unterhalb des zweiten Leitblechs (25) befindet und zwischen dem dritten Leitblech (26) und der externen Lüftungseinheit (22) ein Referenzabstand besteht.

4. Lüftungs- und Wärmeableitungsvorrichtung nach einem der Ansprüche 1 bis 3, wobei die wasserdichte Einheit (21) ferner eine Drehplatte (213) umfasst, wobei
die Drehplatte (213) zu dem Drainageloch (211) passt.

5. Lüftungs- und Wärmeableitungsvorrichtung nach Anspruch 4, wobei die wasserdichte Einheit (21) ferner eine Drehwelle umfasst, wobei
die Drehwelle mit der wasserdichten Platte (212) verbunden ist und die Drehplatte (213) drehbar mit der Drehwelle verbunden ist.

6. Lüftungs- und Wärmeableitungsvorrichtung nach einem der Ansprüche 1 bis 5, wobei die wasserdichte Platte (212) eine erste wasserdichte Unterplatte (2121) und eine zweite wasserdichte Unterplatte (2122) umfasst und zwischen der ersten wasserdichten Unterplatte (2121) und der zweiten wasserdichten Unterplatte (2122) ein Referenzwinkel besteht; und
sich die erste wasserdichte Unterplatte (2121) und die zweite wasserdichte Unterplatte (2122) zwischen der externen Lüftungseinheit (22) und der internen Lüftungseinheit (23) befinden, und eine Unterseite der ersten wasserdichten Unterplatte (2121) mit dem Drainageloch (211) bereitgestellt ist.

7. Lüftungs- und Wärmeableitungsvorrichtung nach einem der Ansprüche 1 bis 6, wobei die Lüftungs- und Wärmeableitungsbaugruppe (2) ferner einen Deflektor (27) zum Leiten des Wassers zu dem Drainageloch (211) umfasst, wobei sich der Deflektor (27) unter der internen Lüftungseinheit (23) befindet und zwischen dem Deflektor (27) und der unteren Platte (14) und der ersten Seitenplatte (11) des Hauptrahmens (1) ein Winkel besteht.

8. Lüftungs- und Wärmeableitungsvorrichtung nach Anspruch 7, wobei sich ein Ende des Deflektors (27) zwischen der unteren Platte (14) des Hauptrahmens (1) und einer Unterseite des Drainagelochs (211) befindet, und das andere Ende des Deflektors (27) in Kontakt mit der ersten Seitenplatte (11) des Hauptrahmens (1) steht.

9. Lüftungs- und Wärmeableitungsvorrichtung nach einem der Ansprüche 1 bis 6, wobei die externe Lüftungseinheit (22) eine Lüftungsplatte (221) umfasst, wobei die Lüftungsplatte (221) eine Vielzahl von Lüftungsöffnungen aufweist und sich die Lüftungsplatte (221) an der ersten Öffnung befindet.

10. Lüftungs- und Wärmeableitungsvorrichtung nach Anspruch 9, wobei die Vielzahl von Lüftungsöffnungen jeweils mit einem Rand bereitgestellt sind und eine konkave Oberfläche des Rands nach unten gerichtet ist.

11. Elektromechanische Vorrichtung, wobei die elektromechanische Vorrichtung die Lüftungs- und Wärmeableitungsvorrichtung nach einem der Ansprüche 1 bis 10 umfasst.

## Revendications

1. Appareil de ventilation et de dissipation de chaleur, dans lequel l'appareil de ventilation et de dissipation de chaleur comprend : un cadre principal (1) conçu pour être relié à un dispositif à ventiler et refroidir, et un ensemble de ventilation et de dissipation de chaleur (2) situé à l'intérieur du cadre principal (1), dans lequel
l'ensemble de ventilation et de dissipation de chaleur (2) comprend une unité étanche (21) pour empêcher de l'eau externe d'entrer dans le dispositif à ventiler et refroidir, une unité de ventilation externe (22) pour permettre à de l'air extérieur d'entrer dans le cadre principal (1), et une unité de ventilation interne (23) pour permettre à la chaleur générée pendant le fonctionnement du dispositif à ventiler et refroidir d'entrer dans le cadre principal (1) ;
l'unité étanche (21), comportant un panneau étanche (212), est située entre l'unité de ventilation externe (22) et l'unité de ventilation interne (23), et l'unité de ventilation externe (22) et l'unité de ventilation interne (23) sont agencées de manière décalée, dans lequel l'unité de ventilation externe (22) et l'unité de ventilation interne (23) sont situées respectivement sur deux côtés du panneau étanche (212) et la position de l'unité de ventilation interne (23) n'est pas plus basse que la position de l'unité de ventilation externe (22) ; et
une partie inférieure du panneau étanche (212) est pourvue d'un trou de drainage (211), de sorte que l'eau externe sur un côté du panneau étanche (212) qui est situé dans l'unité de ventilation interne (23) s'écoule à travers le trou de drainage (211) au niveau de la partie inférieure du panneau étanche (212) et est évacuée à travers l'unité de ventilation externe (22), dans lequel le cadre principal (1) comprend un premier panneau latéral (11), un second panneau latéral (12), un panneau supérieur (13), un panneau inférieur (14) et une paroi latérale (15), dans lequel
le premier panneau latéral (11) est relié à un côté de la paroi latérale (15), le second panneau latéral (12) est relié à l'autre côté de la paroi latérale (15), une extrémité de la paroi latérale (15) est reliée au panneau supérieur (13), et l'autre extrémité de la paroi latérale (15) est reliée au panneau inférieur (14) ; et
la paroi latérale (15) a une première ouverture adaptée à l'unité de ventilation externe (22) et une seconde ouverture adaptée à l'unité de ventilation interne (23), et
dans lequel l'unité de ventilation externe (22) et le cadre principal (1), et l'unité de ventilation interne (23) et le cadre principal (1) sont reliés de manière amovible.

2. Appareil de ventilation et de dissipation de chaleur selon la revendication 1, dans lequel l'ensemble de ventilation et de dissipation de chaleur (2) comprend en outre un premier déflecteur (24) et un deuxième déflecteur (25) disposés de manière décalée de haut en bas, dans lequel
le premier déflecteur (24) est relié à une partie supérieure de l'unité étanche (21), et le deuxième déflecteur (25) est situé au-dessus de l'unité de ventilation externe (22).

3. Appareil de ventilation et de dissipation de chaleur selon la revendication 1 ou 2, dans lequel l'ensemble de ventilation et de dissipation de chaleur (2) comprend en outre un troisième déflecteur (26) situé entre l'unité étanche (21) et le cadre principal (1), dans lequel
le troisième déflecteur (26) est situé en dessous du deuxième déflecteur (25), et il existe une distance de référence entre le troisième déflecteur (26) et l'unité de ventilation externe (22) .

4. Appareil de ventilation et de dissipation de chaleur selon l'une quelconque des revendications 1 à 3, dans lequel l'unité étanche (21) comprend en outre un panneau rotatif (213), dans lequel
le panneau rotatif (213) correspond au trou de drainage (211).

5. Appareil de ventilation et de dissipation de chaleur selon la revendication 4, dans lequel l'unité étanche (21) comprend en outre un arbre rotatif, dans lequel
l'arbre rotatif est relié au panneau étanche (212), et le panneau rotatif (213) est relié en rotation à l'arbre rotatif.

6. Appareil de ventilation et de dissipation de chaleur selon l'une quelconque des revendications 1 à 5, dans lequel le panneau étanche (212) comprend un premier sous-panneau étanche (2121) et un second sous-panneau étanche (2122), et il existe un angle de référence entre le premier sous-panneau étanche (2121) et le second sous-panneau étanche (2122) ; et
le premier sous-panneau étanche (2121) et le second sous-panneau étanche (2122) sont situés entre l'unité de ventilation externe (22) et l'unité de ventilation interne (23), et une partie inférieure du premier sous-panneau étanche (2121) est pourvue du trou de drainage (211).

7. Appareil de ventilation et de dissipation de chaleur selon l'une quelconque des revendications 1 à 6, dans lequel l'ensemble de ventilation et de dissipation de chaleur (2) comprend en outre un déflecteur (27) pour guider l'eau vers le trou de drainage (211), dans lequel
le déflecteur (27) est situé en dessous de l'unité de ventilation interne (23), et il existe un angle entre le déflecteur (27) et le panneau inférieur (14) et le premier panneau latéral (11) du cadre principal (1).

8. Appareil de ventilation et de dissipation de chaleur selon la revendication 7, dans lequel une extrémité du déflecteur (27) est située entre le panneau inférieur (14) du cadre principal (1) et une partie inférieure du trou de drainage (211), et l'autre extrémité du déflecteur (27) est en contact avec le premier panneau latéral (11) du cadre principal (1).

9. Appareil de ventilation et de dissipation de chaleur selon l'une quelconque des revendications 1 à 6, dans lequel l'unité de ventilation externe (22) comprend un panneau de ventilation (221), le panneau de ventilation (221) a une pluralité d'évents d'aération, et le panneau de ventilation (221) est situé au niveau de la première ouverture.

10. Appareil de ventilation et de dissipation de chaleur selon la revendication 9, dans lequel la pluralité d'évents d'aération sont pourvus chacun d'un rebord, et une surface concave du rebord est dirigée vers le bas.

11. Dispositif électromécanique, dans lequel le dispositif électromécanique comprend l'appareil de ventilation et de dissipation de chaleur selon l'une quelconque des revendications 1 à 10.
